# EUROPÄISCHE PATENTSCHRIFT

(11) **EP 0 691 735 B1**
(45) Veröffentlichungstag und Bekanntmachung des Hinweises auf die Patenterteilung: **29.11.2000**
(21) Anmeldenummer: 95110298.7
(22) Anmeldetag: 30.06.1995
(51) Int. Cl.: H03G 1/00, H03G 3/30

(54) **Verstärkeranordnung und Empfängerschaltung, die die Verstärkeranordnung enthält**
Amplifier arrangement and receiver circuit comprising amplifier arrangement
Montage amplificateur et circuit récepteur avec un tel montage d'amplificateur

(30) Priorität: 08.07.1994 DE 4424140
(43) Veröffentlichungstag der Anmeldung: 10.01.1996
(73) Patentinhaber: Infineon Technologies AG, 81541 München (DE)
(72) Erfinder: Fenk, Josef, Dipl.-Ing., D.85386 Eching (DE); Sehrig, Peter, Ing. grad., D-82343 Pöcking (DE); Heinen, Stefan, Dr., D-47802 Krefeld (DE)
(74) Vertreter: Zedlitz, Peter, Dipl.-Inf.

(56) Entgegenhaltungen:
- EP-A- 0 514 818
- GB-A- 2 161 335
- PATENT ABSTRACTS OF JAPAN vol. 008, no. 081 (E-238), 13.April 1984 & JP 59 002415 A (FUJITSU KK), 9.Januar 1984,

## Beschreibung

Die Erfindung bezieht sich auf eine Verstärkeranordnung mit digital einstellbarer Gesamtverstärkung, die mit einer Vielzahl von schaltbaren Einzel-Verstärkern gebildet ist sowie auf eine Empfangerschaltung, insbesondere eine Mobilfunkempfängerschaltung, mit einer solchen Verstärkeranordnung.

Die Empfängerschaltungen von beispielsweise Mobilfunkhandgeraten müssen je nach Entfernung zur Basisstation unterschiedlich hohe Pegel des zu empfangenden Signals verarbeiten können, wobei die Bedingung herrscht, daß das Ausgangssignal des Empfängers einen möglichst konstanten Pegel aufweisen soll. Dieser Ausgangspegel soll dabei nicht nur zeitlich, sondern auch über der Temperatur konstant sein, sowie einen möglichst großen Signal-Rausch-Abstand haben. Außerdem soll er möglichst unabhängig von Betriebsspannungsschwankungen sowie von Fertigungsstreuungen sein.

Eine typische Empfängerschaltung ist in einem Blockschaltbild in der Schrift "An RF Front-End for Digital Mobile Radio" aus IEEE 1990, Bipolar Circuits and Technology Meeting, Seiten 244 bis 247 dargestellt. Eine Antenne wird dort über einen Schalter und ein erstes Filter einem HF-Vorverstärker zugeführt, der mit einem Verstärkungsregelungseingang ausgebildet ist. Dessen Ausgangssignal wird über ein zweites Filter einem ersten Mischer zugeführt. Dessen Ausgangssignal, das Zwischenfrequenzsignal, wird mittels eines SAW-Filters gefiltert und über einen Zwischenfrequenz(ZF)-Verstärker einem zweiten Mischer zugeführt, dessen Ausgangssignal dann das Basisbandsignal ist, das beispielsweise einem A/D-Wandler zugeführt werden kann. Auch der ZF-Verstärker weist einen Eingang zur Regelung dessen Verstärkung auf. Insgesamt wird durch Regelung der Verstärkung des Vorverstärkers und des ZF-Verstärkers der Pegel des Basisbandsignals auf einem annähernd konstanten Wert gehalten, obwohl das an der Antenne anliegende Empfangssignal starke Pegelunterschiede aufweisen kann. Die Verstärker werden dabei dadurch geregelt, daß der Widerstand einer dem Lastwiderstand eines jeweiligen Verstärkers parallel geschalteten Diode mittels einer diese ansteuernde Stromquelle verändert wird. Diese Art der analogen Regelung hat jedoch den Nachteil, daß die Verstärkung für eine vorgegebene Regelspannungsgröße eine zu große Temperaturdrift aufweist und daß die Größe dieser Drift von dem gerade eingestellten Verstärkungswert abhängt. Außerdem sind die Eingangspegel der Differenzstufen dieser Verstärker auf 200mVpp begrenzt und es ändert sich auch die Linearität mit dem Regelstatus. Ein weiterer Nachteil ist, daß sich die Eingangsrauschzahl nicht auf geringstmögliche Werte einstellen läßt.

Aus der Schrift "A 100MHz IF Amplifier/Quadrature Demodulator for GSM Cellular Radio Mobile Terminals "aus IEEE 1990 Bipolar Circuits and Technology Meeting, Seiten 248 bis 251 ist eine digitale Einstellung der Verstärkungswerte des ZF-Verstärkers bei einem Mobilfunkempfänger bekannt. Zu diesem Zweck sind dort vier Verstärker hintereinander geschaltet, die zwischen 0 und 24dB bzw. 0 und 12dB bzw. 0 und 6dB bzw. 0 und 3dB Verstärkung schaltbar sind. Es lassen sich damit also Verstärkungen zwischen 0 und 45dB in Schritten von 3dB einstellen. Der Nachteil dieser bekannten digitalen Einstellung ist jedoch, daß hier nur eine geringstmögliche Schrittweite von 3dB gegeben ist. Außerdem müssen für eine stetige Erhöhung oder Erniedrigung der Gesamtverstärkung einzelne Verstärker immer ein-, aus- und wieder ausgeschaltet werden, wodurch sich die Linearität der Gesamtanordnung verschlechtert.

Die Patentanmeldung GB 2161335A, "Variable gain power amplifier", offenbart eine Verstärkeranordnung mit digitaler Einstellung der Verstärkungswerte. Die erste Stufe ist aus mehreren parallelen Eingangsverstärkern mit unterschiedlichen Verstärkungswerten aufgebaut, deren Eingänge mit dem Eingang des Systems verbunden sind, und von deren Ausgängen einer mit einem Schalter ausgewählt wird. In der zweiten Stufe wird das Signal durch parallele Verstärker mit unterschiedlichen Verstärkungswerten weiter verstärkt, und mit einem Schalter wird einer von den Verstärkerausgängen gewählt.

Es ist somit die Aufgabe vorliegender Erfindung, eine Verstärkeranordnung anzugeben, die eine einstellbare Vestärkung aufweist, die weitgehend unabhängig von Temperatur und Betriebsspannungsschwankungen ist. Außerdem soll sie eine äquivalente Eingangsrauschzahl aufweisen, die bei größter Verstärkung so niedrig wie möglich ist und gleichzeitig sollte sie einen große Aussteuerfähigkeit aufweisen. Eine weitere Aufgabe der Erfindung ist es, eine Empfängerschaltung mit einer solchen Verstärkeranordnung anzugeben, deren Ausgangssignal unabhängig von Schwankungen ihres Empfangssignals, der Temperatur, der Betriebsspannung sowie von Fertigungsstreuungen sein soll.

Diese Aufgabe wird durch die Merkmale des Anspruchs 1 sowie des Anspruchs 13 gelöst.

Vorteilhafte Weiterbildungen der Erfindung sind in den Unteransprüchen angegeben.

Durch die Ausbildung der Verstärkeranordnung mit zumindest zwei parallelen, wahlweise ansteuerbaren Verstärkungspfaden, die jeder mit einem Eingangsverstärker und einem diesem nachgeschalteten, stufenweise schaltbaren Schaltverstärker gebildet sind, wobei die Verstärkungspfade eingangsseitig mit dem Eingang der Verstärkeranordnung und ausgangsseitig mit jeweiligen Eingängen eines Multiplexers verbunden sind, dessen Ausgang den Ausgang der Verstärkeranordnung bildet, ist es möglich, die Verstärkeranordnung derart anzusteuern, daß beispielsweise bei einem schrittweise Abfallen der Verstärkung ein Verstärker immer nur einem ein- und ausgeschaltet werden muß, so daß ein annähernd linearer Verlauf gewährleistet ist. Wenn beispielsweise zwei Verstärkungspfade gegeben sind und der Eingangsverstärker des ersten Pfads eine Verstärkung von 24dB, der Eingangsverstärker des anderen Pfads von 0dB aufweist, und die Schaltverstärker in jeweils 12 Stufen von 2dB zwischen -8dB und 14dB schaltbar sind, so ist ein linearer Verstärkungsverlauf gegeben, wenn zunächst der Schaltverstärker des ersten Pfads schrittweise von 14dB bis -8dB geschaltet wird, so daß die Gesamtverstärkungs sich in Schritten von 2dB von 38dB auf 16dB ändert und dann auf den zweiten Verstärkungspfad umgeschaltet wird, dessen Schaltverstärker dann von 14dB auf -8dB geschaltet wird, so daß sich die Gesamtverstärkung weiter von 14dB auf -8dB und somit auf insgesamt von 38dB auf -8dB linear ändert, wobei pro Schritt immer nur ein Verstärker geschaltet werden muß.

Wenn der Eingangsverstärker des ersten Pfads die größte Verstärkung bringt und ihm ein weiterer Eingangsverstärker parallel geschaltet ist, kann die äquivalente Eingangsrauschzahl minimiert werden, indem dieser Eingangsverstärker so rauscharm wie möglich gemacht wird.

Besonders vorteilhaft ist es, wenn die Eingangsverstärker schaltbar ausgebildet sind und somit die Auswahl eines Verstärkungspfads durch Auswahl eines Eingangsverstärkers erfolgen kann.

Eine besonders geringe Rauschzahl ist erreichbar, wenn in erfindungsgemäßer Weise die Eingangsverstärker als basisgekoppelte Verstärker ausgebildet sind. Um für den abgeschalteten Verstärkungspfad eine ausreichende Vorwärtsübertragungsdämpfung zu erreichen, ist es vorteilhaft, die Schaltverstärker als emittergekoppelte Verstärker auszuführen.

Da die Verstärkung eines Einzelverstärkers nicht beliebig groß gemacht werden kann, kann in erfindungsgemäßer Weiterbildung dem Multiplexer zumindest ein weiterer Schaltverstärker nachgeschaltet werden, wobei auch dieser zumindest eine weitere Schaltverstärker in derselben Schrittweite wie die Schaltverstärker der Verstärkungspfade schaltbar sein sollte.

In erfindungsgemäßer Weise sind die Schaltverstärker mit einer Anzahl von n parallel geschalteten wahlweise einschaltbaren Verstärkern unterschiedlicher Verstärkung gebildet, wobei deren Verstärkung jeweils um denselben Faktor von der Verstärkung eines jeweils anderen Verstärkers desselben Schaltverstärkers verschieden ist. Zur Einstellung der Verstärkung eines Schaltverstärkers wird jeweils einer der n parallel geschalteten Verstärker ausgewählt, während die anderen sperren. Zu diesem Zweck kann der Schaltverstärker beispielsweise von einer n Bit breiten Leitung angesteuert werden, wobei immer nur ein Bit einen Aktivzustand annimmt.

Um ein ständiges Weiterverstärken eines Gleichspannungsoffset zu verhindern, ist in vorteilhafter Weise zumindest einer der weiteren Schaltverstärker kapazitiv angekoppelt. Es können allerdings auch schon die Schaltverstärker in den Verstärkungspfaden kapazitiv angekoppelt sein.

Die Verstärker können in vorteilhafter Weise als Differenzverstärker ausgebildet sein.

Durch geeignete Wahl der Anzahl der Verstärker, Zusammenschaltung der Einzelvestärker zu Schaltverstärkern sowie der Schrittweite der Verstärkung läßt sich der Verstärkungsbereich der Verstärkeranordnung einstellen. Außerdem kann durch geeignete Wahl der Verstärkungsbereiche der Schaltverstärker und geeignete Ansteuerung bei der erfindungsgemäßen Verstärkeranordnung eine lineare Verstärkungskennlinie erreicht werden, dadurch, daß ein Einzelverstärker nur jeweils einmal geschaltet werden muß. Es ist allerdings nicht von Nachteil, wenn mit dem Umschalten von einem Verstärkungspfad auf einen anderen, d. h. also von Eingangsverstärkern, auch innerhalb eines Schaltverstärkers Einzelverstärker ein zweites Mal umgeschaltet werden.

Um die einzelnen Verstärker anzusteuern, kann in Weiterbildung der Erfindung die Verstärkeranordnung mit einer Steuerschaltung versehen sein, die die Signale zum Auswählen einzelner Verstärker liefert. In besonders vorteilhafter Weise ist diese Steuerschaltung von einem 3-Leiter-Bus ansteuerbar. Dabei führt einer der Leiter ein Enable-Signal mit dem die anderen beiden Leiter durchgeschaltet werden können.

Ein anderer Leiter führt ein Taktsignal und der dritte Leiter ein Datensignal, das die Daten für die Einstellung der Verstärkeranordnung enthält. Diese Daten können dann mittels des Taktsignals während eines Aktivzustands des Enable-Signals beispielsweise in ein Schieberegister in der Steuerschaltung eingegeben werden, von wo sie dann entweder direkt oder nach einer Umcodierung zum Schalten der Verstärker verwendet werden.

Um eine hohe Temperaturstabilität zu erreichen, sind in Weiterbildung der Erfindung Mittel zum Erzeugen eines Referenzstromes vorgesehen, die mit den Verstärkern über deren Arbeitungspunktströme in Wirkverbindung stehen. Vorzugsweise werden hierzu Kombinationen von PTC- und NTC-Widerständen verwendet, die beispielsweise von einer Bandgap-Referenzspannung beaufschlagt werden.

Besonders vorteilhaft ist die erfindungsgemäße Verstärkeranordnung bei Verwendung in einer Empfängerschaltung, insbesondere in einer Mobilfunkempfängerschaltung, wo die Gesamtverstärkung hauptsächlich des ZF-Verstärkers so eingestellt und geregelt werden muß, daß unabhängig vom Pegel des HF-Eingangssignals der Pegel des Basisbandsignals einen annähern konstanten Wert hat, da beispielsweise ein dem Empfänger nachgeschaltere A/D-Wandler nur einen eingeschränkten Dynamikbereich hat.

Es kann in vorteilhafter Weise durch die Steuerschaltung der Verstärkeranordnung auch ein schaltbarer HF-Vorverstärker angesteuert werden, so daß der Dynamikbereich der den ZF-Verstärker bildenden erfindungsgemäßen Verstärkeranordnung kleiner gewählt werden kann.

Die Erfindung soll nachfolgend anhand von Ausführungsbeispielen mit Hilfe von Figuren näher erläutert werden. Dabei zeigen:
- Figur 1: ein erweitertes Blockschaltbild einer erfindungsgemäßen Verstärkeranordnung,
- Figur 2: ein detalliertes Schaltbild eines Eingangsverstärkers,
- Figur 3: ein detailliertes Schaltbild eines Schaltverstärker mit acht Einzelverstärkern,
- Figur 4: ein detailliertes Schaltbild eins Multiplexers,
- Figur 5: ein Diagramm, das die Einstellmöglichkeiten der erfindungsgemäßen Verstärkeranordnung darstellt, und
- Figur 6: ein Blockschaltbild einer erfindungsgemäßen Empfängerschaltung mit einer erfindungsgemäßen Verstärkeranordnung.

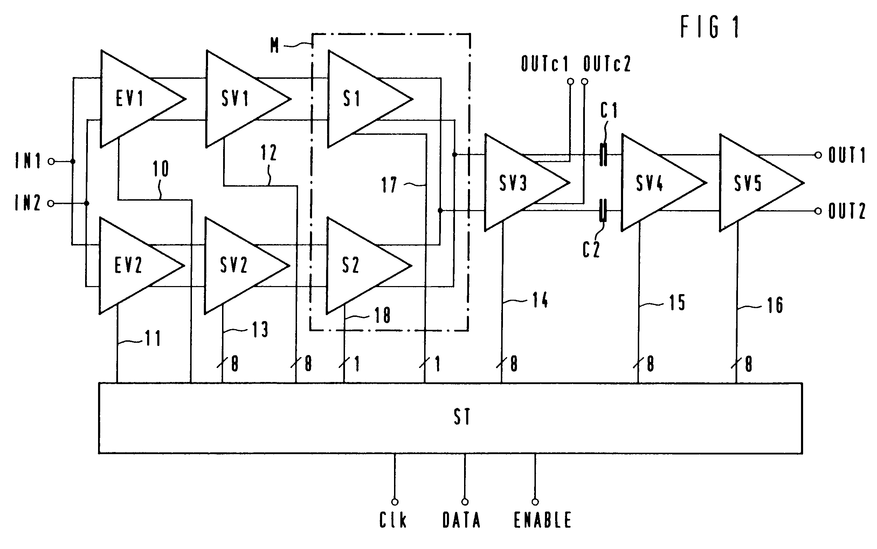

Figur 1 zeigt ein Blockschaltbild einer erfindungsgemäßen Verstärkeranordnung mit einer Vielzahl von Verstärkern EV1, EV2, SV1, SV2, SV3, SV4 und SV5, die alle als Differenzverstärker mit jeweils zwei Eingängen und zwei Ausgängen ausgebildet sind. Die Eingänge zweier Verstärkungspfade 1 und 2 sind mit den zwei Eingangsklemmen in1, in2 der Verstärkeranordnung verbunden. Jeder Verstärkungspfad 1 bzw. 2 enthält einen Eingangsverstärker EV1 bzw. EV2 und einen Schaltverstärker SV1 bzw. SV2. Die Ausgänge der Verstärkungspfade 1, 2 sind mit jeweiligen Eingängen eines Multiplexers M verbunden. Dieser enthält zwei Schalter S1 und S2, deren Ausgänge miteinander verbunden sind und den Ausgang des Multiplexers M bilden. Der Ausgang des Multiplexers M könnte bereits als Ausgang der Verstärkeranordnung dienen. Zur weiteren Verstärkung sind dem Multiplexer jedoch drei weitere Schaltverstärker SV3, SV4, SV5 nachgeschaltet. Der Schaltverstärker SV4 ist über zwei Kondensatoren C1 und C2 an den Schaltverstärker SV3 angekoppelt, um einen Gleichspannungsoffset auszufiltern. Zu diesem Zweck könnte auch ein anderer der Schaltverstärker oder auch mehrere kapazitiv angekoppelt werden. Der Ausgang des letzten Schaltverstärkers SV5 bildet den Ausgang out1, out2 der Verstärkeranordnung. Es können auch weitere Ausgänge herausgeführt werden, beispielsweise um Filterelemente daran anzuschließen, oder wenn eine geringere Gesamtverstärkung zusätzlich gewünscht ist, wie dies mit den Ausgängen outc1 und outc2 des Schaltverstärkers SV3 angedeutet ist.

Die Schaltverstärker SV1...SV5 sind mit jeweils acht parallel geschalteten, wahlweise einschaltbaren Einzelverstärkern gebildet. Es können aber auch mehr Einzelverstärker sein. Sie sind jeweils über eine 8 Bit breite Leitung 12 ... 16 mit einer Steuerschaltung ST verbunden. Jede Leitung der 8 Bit breiten Leitung ist mit einem der acht parallel geschalteten Einzelverstärkern verbunden und kann diesen aktivieren, wobei immer nur einer der Einzelverstärker eines Schaltverstärkers aktiviert ist. Jeder Einzelverstärker weist dabei eine Verstärkung auf, die von der Verstärkung jedes anderen der Einzelverstärker eines jeweiligen Schaltverstärkers unterschiedlich ist. Vorzugsweise sind die Verstärkungen der Einzelverstärker so gewählt, daß durch Weiterschalten von einem zum anderen Einzelverstärker die Verstärkung um einen konstanten Faktor zu- oder abnimmt. In einer bevorzugten Ausgestaltung der Verstärkeranordnung weisen alle Schaltverstärker SV1...SV5 dieselben auswählbaren Verstärkungen auf.

Die Eingangsverstärker EV1, EV2 sind über jeweils eine Steuerleitung 10 bzw. 11 mit der Steuerschaltung ST verbunden und können darüber ausgewählt werden. Die Eingangsverstärker EV1, EV2 weisen unterschiedliche Verstärkungen auf, so daß auch die beiden Verstärkungspfade 1 und 2 unterschiedliche Verstärkungen aufweisen. Die Verstärkungen der Eingangsverstärker EV1 und EV2, die Verstärkungsbereiche der Schaltverstärker SV1...SV5 sowie die Schrittweite, in denen die Schaltverstärker SV1...SV5 schaltbar sind, sind so gewählt, daß jeder Einzelverstärker jedes Schaltverstärkers für jede Wahl eines Verstärkungspfades 1 oder 2 nur einmal geschaltet werden muß, um somit eine lineare Kennlinie der Verstärkeranordnung zu erhalten.

Der Multiplexer M wird über zwei Steuerleitungen 17 und 18, die mit jeweils einem der Schalter S1 bzw. S2 verbunden sind, von der Steuerleitung ST angesteuert. Dadurch kann jeweils der Verstärkungspfad 1 oder 2, dessen Eingangsverstärker EV1 oder EV2 gerade aktiviert ist, auf den Ausgang des Multiplexer M geschaltet werden. Die Steuerschaltung ST hat drei Eingänge Clk, Data, und Enable, über die sie mit einem 3-Leiter-Bus verbunden werden kann. Ein Signal am Enable-Eingang aktiviert die Steuerschaltung ST dahingehend, daß der Data- und der Clk-Eingang freigeschaltet wird. Diese Eingänge brauchen nur freigegeben zu werden, wenn die Verstärkeranordnung umgeschaltet werden muß. Wenn das Signal am Enable-Eingang einen Aktivzustand aufweist, können Daten am Data-Eingang mittels eines Taktsignals am Clk-Eingang in beispielsweise ein Schieberegister der Steuerschaltung ST eingetaktet werden. Diese Daten können dann entweder direkt dazu dienen, die Verstärker EV1, EV2, SV1...SV3 und den Multiplexer M anzusteuern oder aber zuerst mittels Dekodierschaltungen dekodiert werden.

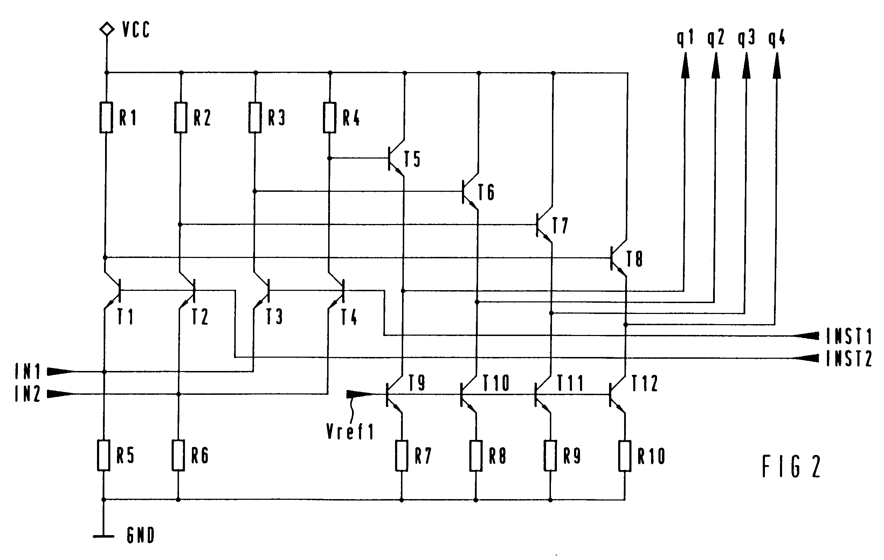

Ein detailliertes Schaltbild für eine mögliche Ausführungsform basisgekoppelter Eingangsverstärker EV1, EV2 zeigt Figur 2. Beide Eingangsverstärker EV1 und EV2 sind mit jeweils zwei Transistoren T3 und T4 bzw. T1 und T2, deren jeweilige Emitteranschlüsse über Widerstände R5 bzw. R6 mit Bezugspotential GND verbunden sind, gebildet. Auf diese Weise sind die Emitteranschlüsse der Transistoren T3 und T1 miteinander verbunden und bilden den ersten Eingangsanschluß in1 der Verstärkeranordnung und es sind die Emitteranschlüsse der Transistor T4 und T2 miteinander verbunden und bilden den zweiten Eingangsanschluß in2 der Verstärkeranordnung. Die Kollektoranschlüsse der Transistoren T1 bis T4 sind jeweils über einen Widerstand R1 bzw. R2 bzw. R3 bzw. R4 mit dem Versorgungsspannungspotential VCC verbunden. Die Basisanschlüsse der Transistoren T3 und T4 sind miteinander und mit einem ersten Steueranschluß inst1 verbunden. Die Basisanschlüsse der Transistor T1 und T2 sind ebenfalls miteinander und mit einem zweiten Steueranschluß inst2 verbunden. Dadurch können wahlweise die Transistor T1 und T2 oder T3 und T4 leitend geschaltet und somit einer der Eingangstransistoren EV1 bzw. EV2 und damit ein Verstärkungspfad 1 bzw. 2 ausgewählt werden. Die unterschiedliche Verstärkung der beiden Eingangsverstärker EV1 bzw. EV2 wird über die Kollektorwiderstände R1 und R2 bzw. R3 und R4 eingestellt. Die Kollektoren der Transistoren sind weiterhin jeweils mit Basisanschlüssen von Ausgangstransistoren T5 bzw. T6 bzw. T7 bzw. T8 verbunden. Die Kollektoranschlüsse dieser Ausgangstransistoren T5 bis T8 sind direkt mit dem Versorgungsspannungspotential VCC und die Emitteranschlüsse jeweils über die Serienschaltung einer Kollektor-Emitter-Strecke eines Transistors T9 bzw. T10 bzw. T11 bzw. T12 und eines Widerstands R7 bzw. R8 bzw. R9 bzw. R10 mit dem Bezugspotential GND verbunden. Die Basisanschlüsse der Transistoren T9 bis T12 sind mit einer Referenzspannung vref1 verbunden. Die Widerstände R1 bis R6 haben einen positiven Temperaturkoeffizienten und die Widerstände R7 bis R10 einen negativen Temperaturkoeffizienten. Die Referenzspannung vref1 wird von einer - nicht dargestellten - Bandgap-Referenzspannung abgeleitet. Durch das Zusammenwirken der Referenzspannung vref1 und der Widerstände R1 bis R10 wird eine hohe Temperaturunabhängigkeit der Vestärkung der Eingangsverstärker EV1 und EV2 erreicht.

Die Ausgänge q1 und q2 bzw. q3 und q4 der Eingangsverstärker EV1, EV2 werden durch die Emitteranschlüsse der Ausgangstransistoren T5 und T6 bzw. T7 und T8 gebildet.

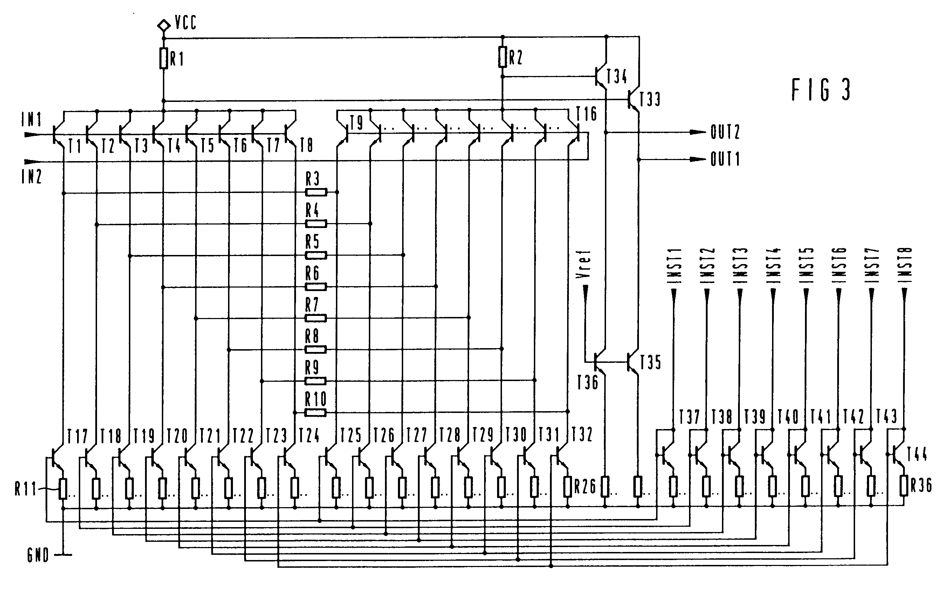

Figur 3 zeigt ein detailliertes Schaltbild einer möglichen Ausführungsform eines Schaltverstärkers SV mit beispielsweise acht als emittergekoppelte Differenzverstärker ausgeführten Einzelverstärkern. Im folgenden wird beispielhaft ein solcher Einzelverstärker anhand mittels des Buchstaben i indizierter Bauteilebezeichnungen beschrieben, wobei i immer von 1 bis 8 gehen soll. Ein Einzelverstärker ist mit zwei Transistoren Tᵢ und Tᵢ₊₈ gebildet, deren Emitteranschlüsse über einen Widerstand Rᵢ₊₂ miteinander und jeweils über die Serienschaltung der Kollektor-Emitter-Strecke von Transistoren Tᵢ₊₁₆ bzw. Tᵢ₊₂₄ und von Widerständen Rᵢ₊₁₀ bzw. Rᵢ₊₁₈ mit dem Massepotential GND verbunden sind. Die Kollektoranschlüsse der Transistoren Tᵢ und Tᵢ₊₈ sind über Widerstände R1 bzw. R2 mit dem Versorgungsspannungspotential VCC verbunden.

Die Basisanschlüsse aller Transistoren Tᵢ sind mit einem ersten Eingangsanschluß in1 und die Basisanschlüsse aller Transistoren Tᵢ₊₈ mit einem zweiten Eingangsanschluß in2 verbunden. Die Verstärkung der jeweiligen Einzelverstärker eines Schaltverstärkers wird über die Widerstände Rᵢ₊₂ eingestellt. Die Kollektoren der Transistoren Tᵢ sind mit dem Basisanschluß eines ersten Ausgangstransistors T33 und die Kollektoranschlüsse der Transistoren Tᵢ₊₈ mit dem Basisanschluß eines zweiten Ausgangstransistors T34 verbunden. Die Kollektoranschlüsse der Ausgangstransistoren T33 und T34 sind mit dem Versorgungsspannungspotential VCC verbunden. Die Emitteranschlüsse der Ausgangstransitoren T33, T34 sind jeweils über die Serienschaltung der Kollektor-Emitter-Strecke von Transistoren T35 bzw. T36 und von Widerständen R27 bzw. R28 mit Bezugspotential GND verbunden und bilden die Ausgangsanschlüsse out1 und out2 des Schaltverstärkers. Die Basisanschlüsse der Transistoren T35, T36 sind mit einem Referenzpotential vref verbunden. Dieses Referenzpotential vref wird in nicht dargestellter Weise von einer Bandgap-Referenzspannung mittels eines PTC- und eines NTC-Widerstandes abgeleitet. Sämtliche Widerstände des in Figur 3 dargestellten Schaltverstärkers haben einen negativen Temperaturkoeffizienten und wirken mit der Arbeitspunktstromeinstellung der Ausgangstransitoren T34, T35 durch das Referenzpotential vref stabilisierend bezüglich der Abhängigkeit der Verstärker von der Temperatur. Die Basisanschlüsse der Transistoren Tᵢ₊₁₆ und Tᵢ₊₂₄ sind jeweils miteinander, mit einem Steuereingang instᵢ sowie über die Serienschaltung einer in Durchlaßrichtung gepolten Diode Tᵢ₊₃₆ und eines Widerstands Rᵢ₊₂₈ mit Bezugspotential GND verbunden. Durch Anlegen eines High-Pegels an einen der Steuereingänge instᵢ wird der dazu gehörende Einzeltransistor des Schaltverstärkers aktiviert und seine Verstärkung definiert dann die Verstärkung des Schaltverstärkers.

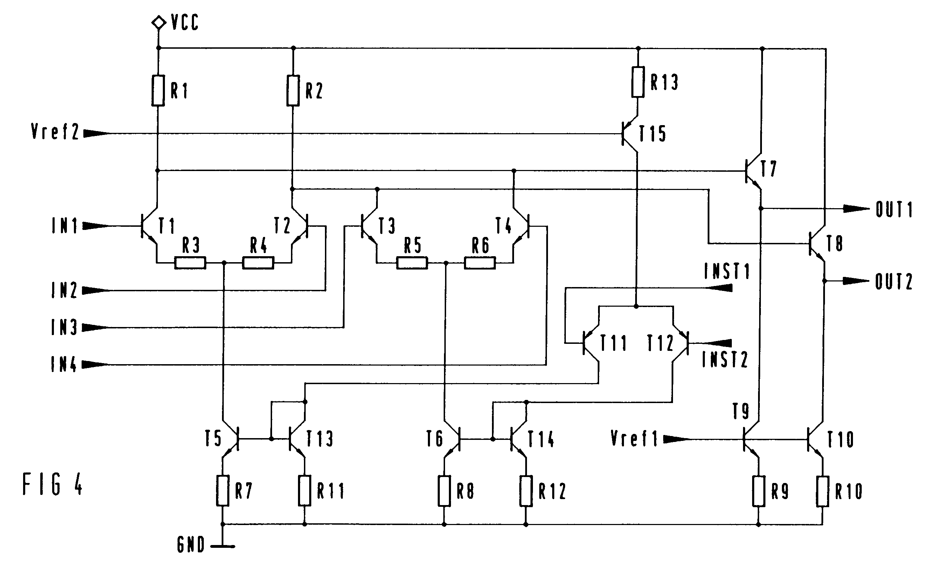

Figur 4 zeigt ein detailliertes Schaltbild einer möglichen Ausführungsform des Multiplexers M, der mit zwei Schaltern S1 und S2 gebildet ist, die jeweils mit Differenzverstärkern gebildet sind. Diese Differenzverstärker können wahlweise aktiviert werden.

Jeder Differenzverstärker ist mit zwei Transistoren T1 und T2 bzw. T3 und T4 gebildet, deren Emitteranschlüsse jeweils über die Serienschaltung zweier Widerstände R3 und R4 bzw. R5 und R6 miteinander verbunden sind. Die Verbindungspunkte der jeweiligen Widerstände R3, R4 bzw. R5, R6 sind über die Serienschaltung der Kollektor-Emitter-Strecke eines Transistors T5 bzw. T6 und eines Widerstands R7 bzw. R8 mit Bezugspotential GND verbunden. Die Kollektoranschlüsse der Transistoren T1 und T4 sind über einen Widerstand R1 und die Kollektoranschlüsse der Transistoren T2 und T3 über einen Widerstand R2 mit dem Versorgungsspannungspotential VCC verbunden. Der Basianschluß des Transistors T1 ist mit einem ersten Eingangsanschluß in1, der Basisanschluß des Transistors T2 mit einem zweiten Eingangsanschluß in2, der Basisanschluß des Transistors mit einem dritten Eingangsanschluß in3 und der Basisanschluß des Transistors T4 mit einem vierten Eingangsanschluß in4 des Multiplexers M verbunden. Die Kollektoranschlüsse der Transistoren T1 und T4 sind mit dem Basisanschluß eines ersten Ausgangstransitors T7 und die Kollektoranschlüsse der Transistoren T2 und T3 mit dem Basisanschluß eines zweiten Ausgangstransitors T8 verbunden. Die Kollektoranschlüsse der Ausgangstransitoren sind direkt mit dem Versorgungsspannungspotential VCC verbunden. Die Emitteranschlüsse der Ausgangstransitoren T7, T8 sind jeweils über die Serienschaltung der Kollektor-Emitter-Strecke von Transistoren T9 bzw. T10 und von Widerständen R9 bzw. R10 mit dem Bezugspotentialanschluß GND verbunden. Die Basisanschlüsse der Transistoren T9 und T10 sind mit einem ersten Referenzspannungspotential vref1 verbunden. Die Basisanschlüsse der Transistoren T5 und T6 sind jeweils mit dem Kollektoranschluß eines Transistors T11 bzw. T12, sowie jeweils über die Serienschaltung einer Diode T13 bzw. T14 und einem Widerstand R11 bzw. R12 mit dem Bezugspotentialanschluß GND verbunden. Die Emitteranschlüsse der Transistoren T11 und T12 sind über die Serienschaltung der Kollektor-Emitter-Strecke eines Transistors T15 und eines Widerstands R13 mit der Versorgungsspannungspotential VCC verbunden. Der Basisanschluß des Transistors T15 ist mit einem zweiten Referenzspannungspotential Vref2 verbunden. Die Basisanschlüsse der Transistoren T13 und T14 sind jeweils mit einem Steueranschluß inst1 bzw. inst2 verbunden. Über die Transistoren T13 und T14 kann einer der Differenzverstärker ausgewählt und aktiviert werden, so daß deren Eingangssignale zum Ausgang des Multiplexers durchgeschaltet werden. Auch bei dem Multiplexer haben alle Widerstände einen negativen Temperaturkoeffizienten und wirken mit den Referenzspannungen vref1 bzw. vref2 temperaturstabilisierend auf die Übertragungseigenschaften des Multiplexers.

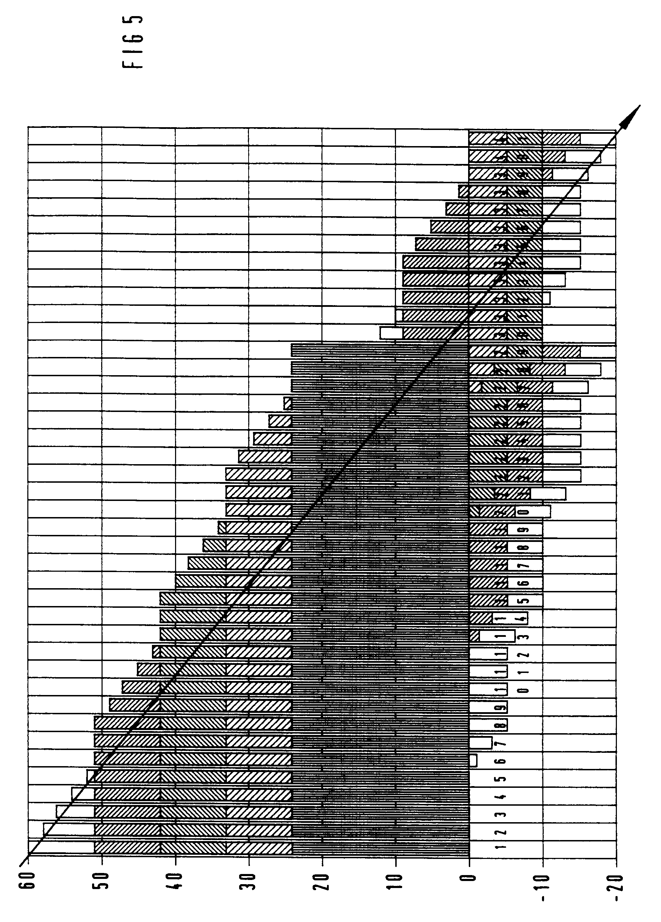

In Figur 5 ist die Verstärkung einer Verstärkeranordnung gemäß Figur 1 in Abhängigkeit von den Verstärkungseinstellungen der Einzelverstärker der jeweiligen Schaltverstärker sowie des gewählten Verstärkungspfades bzw. Eingangsverstärkers dargestellt. Die Einzelverstärker haben dabei eine Verstärkung von 24dB bzw. 0dB und die Schaltverstärker jeweils von -5dB bis 9dB in Schritten von 2dB. Die verschieden schraffierten Bereiche zeigen jeweils die eingestellte Verstärkung eines Schaltverstärkers. Es ist aus Figur 5 deutlich zu erkennen, daß immer nur ein Schaltverstärker um eine Stufe geschaltet werden muß, um einen linearen Verlauf der Gesamtverstärkung zu erhalten. Eine Ausnahme von dieser Regel bildet nur die Umschaltung von einem Einzelverstärker auf den anderen bzw. von einem Verstärkungspfad auf den anderen. Dabei wird auch jeweils ein Einzelverstärker des letzten und vorletzten Schaltverstärkers noch einmal geschaltet. Da dies gleichzeitig mit dem Umschalten des Verstärkungspfads erfolgt, wirkt es sich jedoch nicht nachteilig auf die Linearität aus.

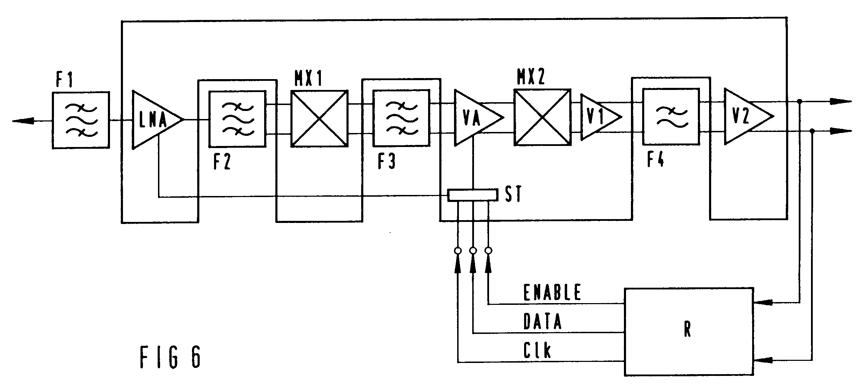

Figur 6 zeigt das Blockschaltbild einer Empfängerschaltung, wie sie beispielsweise in einem Mobilfunkhandgerät verwendet wird und bereits in der Beschreibungseinleitung beschrieben wurde. Es ist zu erkennen, daß alle Verstärker und Mischer und auch die Steuerschaltung für die erfindungsgemäße Vestärkeranordnung auf einem Chip integriert sind. Nur die Filter müssen extern hinzugeschaltet werden. Von der Steuerschaltung kann zusätzlich ein schaltbarer Vorverstärker LNA angesteuert werden. Dadurch kann der Dynamikbereich der Empfangsschaltung erweitert werden. Zum Schalten der Verstärkeranordnung - des Zwischenfrequenzverstärkers - sind nur drei Anschlüsse am den Empfänger bildenden integrierten Baustein nötig. Dadurch kann der IC über ein 3-Leiter-Bussystem mit den anderen, zur Regelung des Pegels des Empfängerausgangssignals nötigen Komponenten(R) verbunden werden.

## Patentansprüche

1. Verstärkeranordnung mit digital einstellbarer Gesamtverstärkung gebildet mit einer Vielzahl von schaltbaren Einzel-Verstärkern
**gekennzeichnet durch**
zumindest zwei parallele, wahlweise ansteuerbare Verstärkungspfade (1, 2),
wobei jeder Verstärkungspfad (1, 2) einen Eingangsverstärker (EV1, EV2) und einen diesem nachgeschalteten stufenweise schaltbaren Schaltverstärker (SV1, SV2) enthält,
wobei die Verstärkungspfade (1, 2) eingangsseitig mit dem Eingang der Verstärkeranordnung und ausgangsseitig mit jeweiligen Eingängen eines Multiplexers (M) verbunden sind, und wobei der Ausgang der Verstärkeranordnung durch den Ausgang des Multiplexers (M) gebildet ist.

2. Verstärkeranordnung nach Anspruch 1,
**dadurch gekennzeichnet,**
daß die Eingangsverstärker (EV1, EV2) schaltbar ausgebildet sind, und
daß die Auswahl eines Verstärkungspfads (1 bzw. 2) durch Auswahl eines Eingangsverstärkers (EV1 bzw. EV2) erfolgt.

3. Verstärkeranordnung nach Anspruch 1 oder 2,
**dadurch gekennzeichnet,**
daß die Eingangsverstärker (EV1, EV2) basisgekoppelte Verstärker sind.

4. Verstärkeranordnung nach einem der Ansprüche 1 bis 3,
**dadurch gekennzeichnet,**
daß die Schaltverstärker (SV1, SV2) emittergekoppelte Verstärker sind.

5. Verstärkeranordnung nach einem der Ansprüche 1 bis 4,
**dadurch gekennzeichnet,** daß dem Multiplexer (M) zumindest ein weiterer Schaltverstärker (SV3, SV4, SV5) nachgeschaltet ist.

6. Verstärkeranordnung nach Anspruch 5,
**dadurch gekennzeichnet,** daß zumindest einer der weiteren Schaltverstärker (SV3, SV4, SV5) kapazitiv angekoppelt ist.

7. Verstärkeranordnung nach einem der Ansprüche 1 bis 6,
**dadurch gekennzeichnet,**
daß die Schaltverstärker (SV1, SV2, SV3, SV4, SV5) mit n parallelgeschalteten, wahlweise einschaltbaren Verstärkern mit unterschiedlicher Verstärkung gebildet sind, deren Verstärkung jeweils um denselben Faktor von der Verstärkung eines jeweils anderen Verstärkers desselben Schaltverstärkers verschieden ist.

8. Verstärkeranordnung nach einem der Ansprüche 1 bis 7,
**dadurch gekennzeichnet,**
daß alle Verstärker (EV1, EV2, SV1, SV2, SV3, SV4, SV5) Differenzverstärker sind.

9. Verstärkeranordnung nach einem der Ansprüche 1 bis 8,
**dadurch gekennzeichnet,**
daß die einzelnen Verstärker (EV1, EV2, SV1, SV2, SV3, SV4, SV5) derart zusammenschaltbar sind, daß sich ein linearer Verlauf der Gesamtverstärkung ergibt.

10. Verstärkeranordnung nach einem der Ansprüche 1 bis 9,
**dadurch gekennzeichnet,**
daß eine die einzelnen Verstärker (EV1, EV2, SV1, SV2, SV3, SV4, SV5) ansteuernde Steuerschaltung (ST) vorgesehen ist.

11. Verstärkeranordnung nach Anspruch 10,
**dadurch gekennzeichnet,**
daß die Steuerschaltung (ST) mit einem 3-Leiter-Bus ansteuerbar ist.

12. Verstärkeranordnung nach einem der Ansprüche 1 bis 11,
**dadurch gekennzeichnet,**
daß Mittel zum Erzeugen eines Referenzstromes vorgesehen sind, die mit den Verstärkern über deren Arbeitspunktströme derart in Wirkverbindung stehen, daß die Gesamtverstärkung annähernd temperaturunabhängig ist.

13. Mobilfunkempfänger mit einer Verstärkeranordnung nach einem der Ansprüche 1 bis 12, wobei Mittel (ST) vorgesehen sind, die die Gesamtverstärkung der Verstärkeranordnung derart einstellen, daß das Ausgangssignal des Mobilfunkempfängers einen konstanten Pegel aufweist.

14. Mobilfunkempfänger nach Anspruch 13, **dadurch gekennzeichnet,** daß ein Vorverstärker (LNA) vorgesehen ist, der ebenfalls von den Mitteln (ST) zum Einstellen der Gesamtverstärkung ansteuer- und einstellbar ist.

15. Mobilfunkempfänger nach Anspruch 13 oder 14, **dadurch gekennzeichnet,** daß die Mittel (ST) zum Einstellen der Gesamtverstärkung von einem 3-Leiter-Bus ansteuerbar sind.

## Claims

1. Amplifier arrangement with a digitally adjustable total gain formed by a multiplicity of switchable individual amplifiers,
**characterized by**
at least two parallel, optionally drivable gain paths (1, 2),
in which case each gain path (1, 2) contains an input amplifier (EV1, EV2) and a switching amplifier (SV1, SV2) which is connected downstream of the latter and is switchable in stages,
in which case the gain paths (1, 2) are connected on the input side to the input of the amplifier arrangement and on the output side to respective inputs of a multiplexer (M), and
in which case the output of the amplifier arrangement is formed by the output of the multiplexer (M).

2. Amplifier arrangement according to Claim 1,
**characterized**
in that the input amplifiers (EV1, EV2) are of switchable design, and
in that a gain path (1 or 2) is selected by selection of an input amplifier (EV1 or EV2, respectively).

3. Amplifier arrangement according to Claim 1 or 2,
**characterized**
in that the input amplifiers (EV1, EV2) are base-coupled amplifiers.

4. Amplifier arrangement according to one of Claims 1 to 3,
**characterized**
in that the switching amplifiers (SV1, SV2) are emitter-coupled amplifiers.

5. Amplifier arrangement according to one of Claims 1 to 4,
**characterized**
in that at least one further switching amplifier (SV3, SV4, SV5) is connected downstream of the multiplexer (M).

6. Amplifier arrangement according to Claim 5, **characterized** in that at least one of the further switching amplifiers (SV3, SV4, SV5) is capacitively coupled.

7. Amplifier arrangement according to one of Claims 1 to 6,
**characterized**
in that the switching amplifiers (SV1, SV2, SV3, SV4, SV5) are formed by n parallel-connected amplifiers having a different gain which can be switched on optionally and whose gain differs in each case by the same factor from the gain of a respective other amplifier of the same switching amplifier.

8. Amplifier arrangement according to one of Claims 1 to 7,
**characterized**
in that all the amplifiers (EV1, EV2, SV1, SV2, SV3, SV4, SV5) are differential amplifiers.

9. Amplifier arrangement according to one of Claims 1 to 8,
**characterized**
in that the individual amplifiers (EV1, EV2, SV1, SV2, SV3, SV4, SV5) can be interconnected in such a way as to produce a linear profile of the total gain.

10. Amplifier arrangement according to one of Claims 1 to 9,
**characterized**
in that a control circuit (ST) is provided which drives the individual amplifiers (EV1, EV2, SV1, SV2, SV3, SV4, SV5).

11. Amplifier arrangement according to Claim 10,
**characterized**
in that the control circuit (ST) can be driven by means of a 3-conductor bus.

12. Amplifier arrangement according to one of Claims 1 to 11,
**characterized**
in that means for generating a reference current are provided, which are operatively connected to the amplifiers by way of the operating point currents thereof in such a way that the total gain is approximately independent of temperature.

13. Mobile radio receiver having an amplifier arrangement according to one of Claims 1 to 12, in which case means (ST) are provided which set the total gain of the amplifier arrangement in such a way that the output signal of the mobile radio receiver has a constant level.

14. Mobile radio receiver according to Claim 13, **characterized** in that a preamplifier (LNA) is provided, which can likewise be driven and set by the means (ST) for setting the total gain.

15. Mobile radio receiver according to Claim 13 or 14, **characterized** in that the means (ST) for setting the total gain can be driven by a 3-conductor bus.

## Revendications

1. Montage amplificateur à gain total pouvant être réglé de manière numérique comportant une pluralité d'amplificateurs individuels pouvant être commutés
caractérisé par
au moins deux voies (1, 2) d'amplification parallèles, pouvant être commandées au choix,
chaque voie (1, 2) d'amplification contenant un amplificateur (EV1, EV2) d'entrée et un amplificateur (SV1, SV2) de commutation monté en aval de l'amplificateur d'entrée et pouvant être commuté par étapes,
les voies (1, 2) d'amplification étant reliées côté entrée à l'entrée du montage amplificateur et côté sortie aux entrées associées d'un multiplexeur (M), et
la sortie du montage amplificateur étant formée par la sortie du multiplexeur (M).

2. Montage amplificateur suivant la revendication 1,
caractérisé
en ce que les amplificateurs (EV1, EV2) d'entrée sont réalisés de manière à pouvoir être commutés, et
en ce que la sélection d'une voie (1 ou 2) d'amplification s'effectue par sélection d'un amplificateur (EV1 ou EV2) d'entrée.

3. Montage amplificateur suivant la revendication 1 ou 2,
caractérisé en ce que
les amplificateurs (EV1, EV2) d'entrée sont des amplificateurs couplés par la base.

4. Montage amplificateur suivant l'une des revendications 1 à 3, caractérisé en ce que
les amplificateurs (SV1, SV2) de commutation sont des amplificateurs couplés par l'émetteur.

5. Montage amplificateur suivant l'une des revendications 1 à 4,
caractérisé en ce que
au moins un amplificateur (SV3, SV4, SV5) supplémentaire est branché en aval du multiplexeur (M).

6. Montage amplificateur suivant la revendication 5,
caractérisé en ce qu'au moins l'un des amplificateurs (SV3, SV4, SV5) de commutation supplémentaire est raccordé de manière capacitive.

7. Montage amplificateur suivant l'une des revendications 1 à 6,
caractérisé en ce que
les amplificateurs (SV1, SV2, SV3, SV4, SV5) de commutation sont formés par n amplificateurs à gains différents qui sont branchés en parallèle, qui peuvent être branchés au choix et dont le gain est différent chaque fois du même facteur du gain d'un autre amplificateur du même amplificateur de commutation.

8. Montage amplificateur suivant l'une des revendications 1 à 7,
caractérisé en ce que
tous les amplificateurs (EV1, EV2, SV1, SV2, SV3, SV4, SV5) sont des amplificateurs différentiels.

9. Montage amplificateur suivant l'une des revendications 1 à 8,
caractérisé en ce que
les amplificateurs (EV1, EV2, SV1, SV2, SV3, SV4, SV5) individuels sont branchés ensemble de telle manière que l'on obtient une courbe linéaire du gain total.

10. Montage amplificateur suivant l'une des revendications 1 à 9,
caractérisé en ce que
il est prévu un circuit (ST) de commande commandant les amplificateurs (EV1, EV2, SV1, SV2, SV3, SV4, SV5) individuels.

11. Montage amplificateur suivant la revendication 10,
caractérisé en ce que
le circuit (ST) de commande peut être commandé par un bus à trois conducteurs.

12. Montage amplificateur suivant l'une des revendications 1 à 11, caractérisé en ce que
il est prévu des moyens pour produire un courant de référence qui sont en liaison active avec les amplificateurs par l'intermédiaire de leur courant de point de fonctionnement de telle manière que le gain total est à peu près indépendant de la température.

13. Récepteur de radiocommunications comportant un montage amplificateur suivant l'une des revendications 1 à 12, des moyens étant prévus qui règlent le gain total du montage amplificateur de telle manière que le signal de sortie du récepteur de radiocommunications a un niveau constant.

14. Récepteur de radiocommunications suivant la revendication 13, caractérisé en ce qu'il est prévu un préamplificateur (LNA) qui peut être commandé et réglé également par des moyens (ST) de réglage du gain total.

15. Récepteur de radiocommunications suivant la revendication 13 ou 14, caractérisé en ce que les moyens (ST) de réglage du gain total peuvent être commandés par un bus à trois conducteurs.
